Europäisches Patentamt

European Patent Office

Office européen des brevets

(11) Numéro de publication: **0 376 388**
**A1**

## (12) DEMANDE DE BREVET EUROPEEN

(21) Numéro de dépôt: 89203265.7

(51) Int. Cl.5: **H03B 19/14, H03K 5/00**

(22) Date de dépôt: 20.12.89

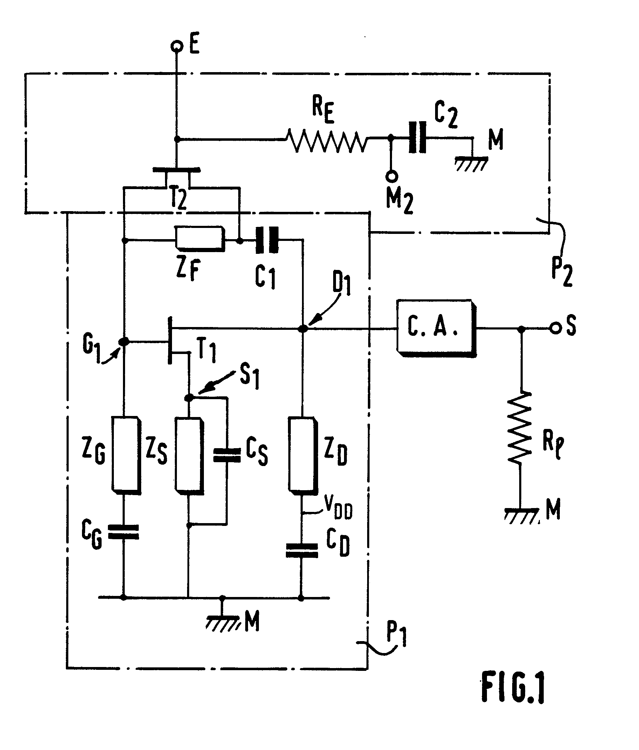

Une requête en rectification de la figure 1 a été présentée conformément à la règle 88 CBE. Il est statué sur cette requête au cours de la procedure engagée devant la division d'examen (Directives relatives à l'examen pratiqué à l'OEB, A-V, 2.2).

(30) Priorité: 30.12.88 FR 8817495

(43) Date de publication de la demande:
04.07.90 Bulletin 90/27

(84) Etats contractants désignés:
**CH DE FR GB IT LI**

(71) Demandeur: **LABORATOIRES D'ELECTRONIQUE PHILIPS**
**3, Avenue Descartes**
**F-94450 Limeil-Brévannes(FR)**

(84) **FR**

(71) Demandeur: **N.V. Philips' Gloeilampenfabrieken**
**Groenewoudseweg 1**
**NL-5621 BA Eindhoven(NL)**

(84) **CH DE GB IT LI**

(72) Inventeur: **Gamand, Patrice**
**Société CIVILE S.P.I.D. 209 rue de l'Université**
**F-75007 Paris(FR)**
Inventeur: **Gabillard, Bertrand**
**Société CIVILE S.P.I.D. 209 rue de l'Université**
**F-75007 Paris(FR)**

(74) Mandataire: **Landousy, Christian et al**
**Société Civile S.P.I.D. 209, Rue de l'Université**
**F-75007 Paris(FR)**

(54) Dispositif semiconducteur intégré incluant un diviseur de fréquences pour applications hyperfréquences.

(57) Dispositif semiconducteur intégré incluant un circuit diviseur de fréquence par deux comprenant un oscillateur étage inverseur ($T_1$) qui forme avec un élément réactif ($Z_f$) une résistance négative, et muni d'un interrupteur commandé ($T_2$) par un signal d'entrée (E) à une fréquence donnée, qui est disposé en parallèle sur l'élément réactif $Z_f$.

Le contrôle de l'oscillateur par l'interrupteur se fait en remplissant les conditions suivantes:

$\tau_2 > \tau_0$

$1/2 (\tau_0 + \tau_1) < f_0 < 1/(\tau_0 + \tau_1)$

$1/(\tau_1 + \tau_2) < f_0$

où $\tau_0$ est le temps de fermeture de l'interrupteur,

$\tau_1$ est le retard apporté par l'étage inverseur,

$\tau_2$ est le temps de transit dans l'élément réactif $Z_f$.

$f_0$ est la fréquence du signal d'entrée E.

Le circuit peut avantageusement être appliqué dans des circuits hyperfréquences intégrés et notamment sources de fréquences stabilisées, diviseurs programmables permettant de synthétiser un ensemble de fréquences stabilisées.

FIG.1

# DISPOSITIF SEMICONDUCTEUR INTEGRE INCLUANT UN DIVISEUR DE FREQUENCES POUR APPLICATIONS HYPERFREQUENCES

L'invention concerne un dispositif semiconducteur intégré incluant un circuit diviseur de fréquence par deux comprenant un étage inverseur et un interrupteur commandé par un signal d'entrée à une fréquence donnée.

L'invention trouve son application dans la réalisation de circuits hyperfréquences intégrés sur arséniure de gallium, notamment dans la réalisation de sources de fréquence stabilisée ou de diviseurs programmables permettant de synthétiser un ensemble de fréquences stabilisées.

Il est généralement connu de l'état de la technique qu'un circuit diviseur de fréquences par deux réalisé en mode dynamique, comportant un étage inverseur, un étage suiveur et un étage interrupteur, est limité par le temps de propagation (tpd) d'une porte.

Un tel circuit diviseur est décrit dans la publication intitulée "26 GHz GaAs Room-Temperature Dynamic Divider Circuit" par J.F.Jensen, L.G. Salmon et alii dans "GaAs Ic Symposium, pp.201-204" Réf. CH 2506-4/87/0000-0201, 1987 IEEE.

Ce document concerne un circuit diviseur de fréquences par deux fonctionnant en dynamique, fondé sur l'utilisation de transistors à effet de champ à désertion montrant une tension de pincement d'environ -2,5 V. Ce diviseur est composé de deux étages (voir la figure 5 du document cité).

Le premier étage est formé d'un transistor interrupteur commandé par un premier signal d'horloge $\phi$, suivi d'une porte inverseuse de type BFL. Le second étage est formé d'un transistor interrupteur commandé par un second signal d'horloge $\phi$ complémentaire suivi d'une porte suiveuse.

Ce circuit connu présente l'avantage d'être réalisable au moyen d'un nombre de transistors peu élevé. Cependant, dans le domaine technique des applications envisagées, il présente encore un certain nombre d'inconvénients. Notamment la fréquence maximale est limitée par le temps de propagation des deux portes, cette fréquence maximale s'exprimant par la relation

$F_{max} = 1/2tpd$.

Les états logiques étant stockés en chargeant ou en déchargeant les capacités de grille des transistors inverseurs et suiveurs, il en résulte que des temps de propagation en charge (tpd) inférieurs à 15 ps nécessaires pour diviser des signaux émis aux fréquences supérieures à 30 GHz, sont impossibles à obtenir dans l'état actuel de la technique au moyen de ce type de diviseur.

D'autre part, dans l'état actuel de la technique, il est extrêmement difficile d'obtenir la complémentarité correcte des signaux d'horloge à des fréquences aussi élevées que 30 GHz, et pratiquement impossible si les fréquences sont encore plus élevées.

La présente invention a pour but de proposer un circuit qui est dénué des inconvénients précités.

Selon l'invention, ce but est atteint au moyen du dispositif défini dans le préambule et en outre caractérisé en ce que l'arrangement du circuit diviseur comprend :

- un oscillateur formé de l'étage inverseur muni d'un élément réactif $Z_f$ générant une résistance négative,
- l'interrupteur disposé en parallèle sur l'élément réactif $Z_f$,
- le contrôLe de l'oscillateur par l'interrupteur en remplissant les conditions :

$\tau_2 > \tau_0$

$(1/2) (\tau_0 + \tau_1) < f_0 < 1 (\tau_0 + \tau_1)$

$1 (\tau_1 + \tau_2) < f_0$

ou $\tau_0$ est le temps de fermeture de l'interrupteur,

$\tau_1$ est le retard apporté par l'étage inverseur,

$\tau_2$ est le temps de transit dans l'élément réactif $Z_f$.

$f_0$ est la fréquence du signal d'entrée E.

Dans ces conditions, le dispositif selon l'invention présente entre autres les avantages suivants :

- il ne nécessite l'utilisation que d'un seul signal d'entrée et non pas de signaux de commande complémentaires ;

- il présente une fréquence maximale plus élevée que celle des dispositifs connus de l'état de la technique.

Dans une mise en oeuvre, ce dispositif est caractérisé en ce que, dans l'oscillateur, l'étage inverseur comprend un transistor à effet de champ $T_1$ muni d'impédances d'accord et en ce que l'interrupteur comprend un transistor à effet de champ $T_2$ dont la source et le drain sont respectivement reliés aux extrémités de l'élément réactif $2f$ et dont la grille reçoit le signal d'entrée E.

Dans ces conditions, le dispositif selon l'invention présente en outre les avantages suivants :

- la fréquence maximale pourra atteindre théoriquement la valeur $F_{max} \simeq 1/2 \tau_0$, où $\tau_0$ est le temps de transit des porteurs sous la grille du transistor inverseur, ce qui peut conduire à des fréquences supérieures à 60 GHz, soit pratiquement le double des limites de l'art antérieur ;
- un gain de conversion pourra être obtenu, lorsqu'on adjoint en sortie un circuit d'adaptation.

L'invention sera mieux comprise au moyen de la description suivante illustrée par les figures annexées dont :

- la figure 1 qui représente le circuit schématique selon l'invention ;
- la figure 2 qui représente en traits discontinus, sur la courbe A, le signal d'entrée hyperfréquences, et en trait plein, sur la courbe B, le signal de sortie hperfréquences divisé par 2 ;
- la figure 3 qui représente le séquencement des signaux dans le circuit.

Tel que représenté schématiquement sur la figure 1, le circuit selon l'invention comprend un premier bloc $P_1$ oscillateur et un second bloc $P_2$ interrupteur, commandé par un unique signal d'entrée E de fréquence $f_o$ qui sera divisée par deux par le circuit selon l'invention. Le bloc $P_1$ comprend un étage inverseur à un transistor à effet de champ $T_1$, et le bloc $P_2$ comprend un transistor a effet de champ $T_2$ monté en interrupteur.

Pour former un oscillateur, d'abord une résistance négative est générée au moyen d'un élément réactif, c'est-à-dire une impédance $Z_F$ disposée entre la grille et le drain du transistor $T_1$ de l'étage inverseur.

Pour former un oscillateur, le transistor à effet de champ $T_1$ de l'étage inverseur est aussi muni de préférence d'impédances d'accord. Il comprend par exemple une première impédance $Z_G$ connectée d'une part à sa grille et d'autre part à la masse à travers une capacité de découplage $C_G$. Il comprend de même par exemple une impédance $Z_D$ connectée d'une part à son drain et d'autre part à la masse à travers une capacité de découplage $C_D$. Il comprend aussi par exemple une impédance $Z_S$ reliant sa source directement à la masse.

Le circuit diviseur est alors réalisé du fait que l'interrupteur $T_2$ de l'étage $P_2$ est placé en parallèle sur l'élément réactif $Z_F$.

Dans une mise en oeuvre, le bloc $P_2$ comprend aussi une charge $R_E$, qui peut être une résistance, pour adapter le transistor $T_2$ au générateur du signal d'entrée E en hyperfréquences. Cette charge $R_E$ est disposée entre le générateur du signal E, et la masse ; d'autre part, par le moyen du générateur, le signal hyperfréquences E est appliqué au circuit au point commun à la charge $R_E$ et à l'électrode de commande (ou grille) du transistor interrupteur $T_2$ de l'étage $P_2$.

Dans une variante de l'invention particulièrement intéressante, la charge $R_E$ peut être reliée à la masse M à travers une capacité de découplage $C_2$, une tension de polarisation continue étant alors appliquée au point $M_2$, commun à la charge et à la capacité, pour éviter la présence d'un signal de sortie résiduel, en l'absence d'un signal d'entrée.

L'étage inverseur est en outre muni de préférence d'une charge $R_\ell$ placée entre le drain du transistor $T_1$ de l'étage inverseur et la masse, la sortie hyperfréquences S se faisant alors sur le drain de ce transistor $T_1$.

Un circuit d'adaptation de puissance symbolisé par le bloc C.A sur la figure 1, peut aussi être disposé entre le transistor $T_1$ et cette charge $R_\ell$, pour permettre un gain de conversion, la sortie du signal hyperfréquences S se faisant alors entre le circuit d'adaptation C.A et la charge $R_\ell$.

Les avantages du circuit selon l'invention seront mieux compris en étudiant le principe de fonctionnement de ce diviseur.

Considérons le schéma électrique représenté sur la figure 1. Soit $\tau_1$ le retard apporté par le transistor $T_1$ chargé par les impédances d'accord $Z_G$, $Z_S$ et $Z_D$. Ce retard $\tau_1$ est en fait la somme du temps de transit $\tau_0$ dans le transistor $T_1$ seul et non chargé et du temps moyen de charge et de décharge des impédances précitées.

Soit encore $\tau_2$ le retard apporté par l'impédance $Z_F$ placée entre la grille et le drain du transistor $T_1$ de l'étage $P_1$, et soit $T_0$ la période du signal E de fréquence $f_0$ d'entrée.

D'autre part, $\tau_0$ est également, par choix de simplification, le temps de transit dans le transistor interrupteur $T_2$.

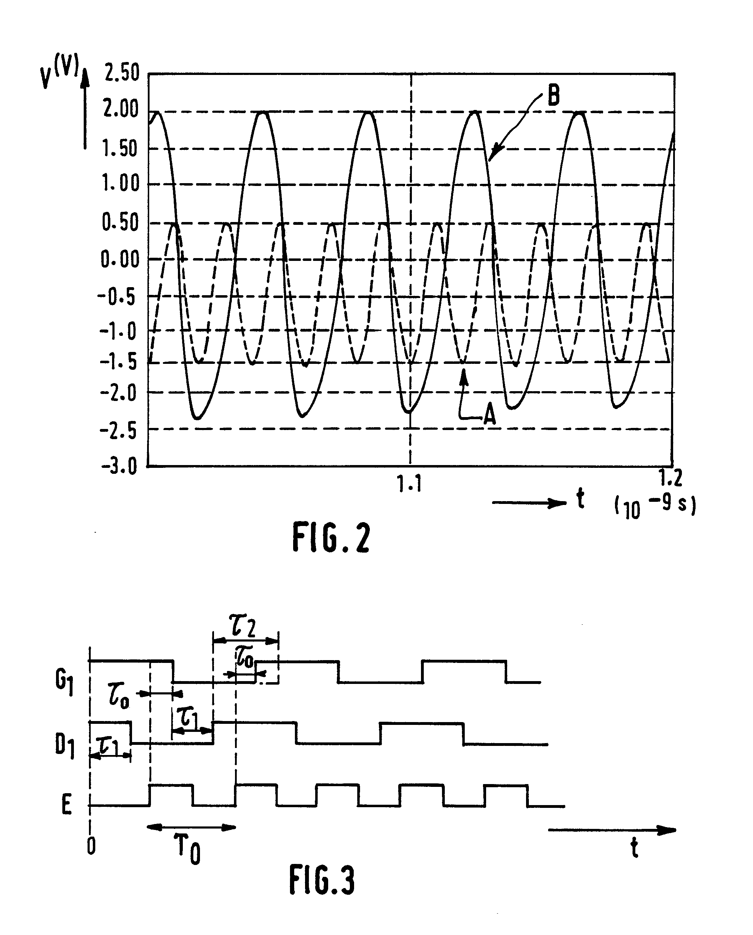

Le diagramme de la figure 3 montre les formes d'ondes aux points $G_1$ (grille du transistor $T_1$) $D_1$ (drain du transistor $T_1$) du circuit en fonction du signal d'entrée E. Le rapport cyclique du signal E est supposé égal à 1.

Le diagramme de la figure 3 montre que les deux signaux aux noeuds $G_1$ et $D_2$ sont bien à la fréquence moitié de la fréquence du signal d'entrée E. Ceci est vrai dans les conditions où les relations suivantes sont vérifiées :

$\tau_0 + \tau_1 > T_0/2$     (1)

$\tau_0 + \tau_1 < T_0$     (2)

Les relations (1) et (2) peuvent se mettre sous la forme de la relation (3) suivante :

$T_0/2 < \tau_0 + \tau_1 < T_0$     (3)

D'autre part, pour que la fréquence de sortie S soit la moitié de la fréquence $f_0$ du signal d'entrée E, il faut qu'en même temps la relation suivante soit vérifiée :

$\tau_0 + \tau_1 + \tau_2 > T_0 + \tau_0$    (4)

ce qui revient à la condition suivante :

$$T_0/2 < \frac{\tau_1 + \tau_2}{2} \qquad (5)$$

Les conditions (1) et (2) signifient que le signal, après avoir traversé le transistor $T_2$ puis le transistor $T_1$, doit être arrêté par le transistor $T_1$. A cet effet, ce dernier doit alors être dans son état bloqué. Par conséquent, c'est le signal d'entrée E, qui, en rendant le transistor $T_2$ passant, permet au signal qui se propage dans le circuit de refaire un tour dans la boucle, ce signal étant alors à une fréquence moitié de celle du signal d'entrée E.

La condition (4) exprime le fait que le transistor $T_2$ interrupteur ne peut rester bloqué durant un temps supérieur à $(\tau_1 + \tau_2)/2$, sinon l'impédance $Z_F$ finira par court-circuiter l'entrée $G_1$ avec la sortie $D_1$ du transistor $T_1$.

La période $T_0$ s'exprimant en fonction de la fréquence $f_0$ du signal d'entrée E par la relation :

$f_0 = 1/T_0$    (6)

on déduit des relations (1) à (6) précédentes, les relations suivantes :

$1/2 (\tau_0 + \tau_1) < f_0 < 1/(\tau_0 + \tau_1)$    (7)

$1/(\tau_1 + \tau_2) < f_0$    (8)

$\tau_2 > \tau_0$    (9)

Ainsi, l'impédance $Z_F$ disposée entre la grille et le drain du transistor $T_1$ présente l'avantage de générer une résistance négative et permet donc au transistor $T_1$ d'osciller alors que la charge de ce dernier reste faible. Comme le temps $\tau_1$ dépend de la charge, ce temps $\tau_1$ peut être fortement réduit par rapport aux dispositifs connus de l'état de la technique. Comme la fréquence maximale d'entrée est limitée par ce temps $\tau_1$, ce temps $\tau_1$ étant réduit, la fréquence maximale d'entrée $f_{0max}$ peut être considérablement augmentée. C'est pourquoi selon l'invention on peut atteindre des fréquences maximales d'entrée supérieures à 60 GHz alors que l'état de la technique ne dépassait pas 30 GHz.

Ainsi, les grandeurs connues de l'homme du métier sont en particulier la fréquence maximale d'oscillation $f_u$ et le temps de transit $\tau_0$ du transistor $T_1$. Au premier ordre, l'homme du métier sait que $f_u$ et $\tau_0$ sont liés par la relation :

$f_u \simeq 1/2,476 \, \tau_0$ pour le transistor $T_1$. En considérant que le retard $\tau_1$ minimal ne peut qu'être égal à $\tau_0$, la relation (7) permet de déduire la fréquence maximale $f_{0max}$ que l'on peut appliquer au diviseur. La condition de fonctionnement se pose alors sous la forme

$0,619 < f_0 < 1,238 \, f_u$    (10)

La figure 2 montre en trait plein sur la courbe B, la forme du signal de sortie dont l'amplitude est portée en volts en ordonnée, en fonction du temps t, en abscisse, en $10^{-9}$ S.

La courbe A de la figure 2 montre la forme du signal d'entrée avec les mêmes unités.

Dans l'exemple représenté par la figure 2, le signal d'entrée est à la fréquence $f_0 = 50$ GHz (courbe A) et le signal de sortie est à la fréquence $f_0/2 = 25$ GHz (courbe B).

Les niveaux du signal d'entrée (courbe A) vont de -1,6V à +0,5V. Les niveaux du signal de sortie (courbe B) vont de -2,4V à +2V.

Le gain de conversion $G_C$ se calcule en utilisant la relation : $G_c = P_S/P_E$

où $P_S$ est la puissance disponible dans la charge $R_\ell$ égale au carré de la tension de sortie efficace $V_{Seffi}$. divisée par la résistance de charge $R_\ell$, ce qui s'écrit :

$P_S = (V_{Seffi})^2 / R_\ell$

$= [V_{S(Haut)} - V_{S(Bas)}]^2/8.R_\ell$

et où $P_E$ est la puissance disponible aux bornes de la résistance d'entrée $R_E$, choisie égale à 50 $\Omega$.

$P_E = [V_{E(Haut)} - V_{E(Bas)}]^2/(8 \times 50)$

Dans un exemple de réalisation de l'invention, on a choisi $R_\ell = 200 \, \Omega$, le gain de conversion calculé à l'aide des expressions précédentes vaut :

$G_c + 0,1$ dB.

Comme il est montré sur la figure 1, d'une façon favorable, les impédances $Z_G$ et $Z_D$ peuvent être constituées d'une inductance localisée ou d'une ligne de transmission de nature inductive qui peuvent alors être notées $L_G$ et $L_D$ respectivement. Ces lignes peuvent être déposées sur un substrat isolant ou semi-isolant par exemple. L'impédance $Z_S$ peut être constituée d'une ligne $L_S$ de structure équivalente associée ou non à une capacité $C_S$ montée en parallèle.

L'impédance $Z_f$ peut être constituée d'une ligne de transmission $L_f$ en série avec une capacité $C_1$. La capacité $C_1$ est destinée à éviter le court-circuit du transistor interrupteur $T_2$ par la ligne $L_f$ en continu.

Le circuit peut être réalisé de façon monolithique de préférence sur un substrat en arséniure de gallium. Les transistors sont alors choisis du type dit MESFET, ou HEMT, à désertion.

Le tableau I suivant donne les valeurs préférées pour les éléments appropriés à réaliser le circuit selon l'invention.

Le tableau II suivant donne les valeurs des tensions pour le fonctionnement du circuit réalisé au moyen des éléments dont les caractéristiques sont rassemblées dans le tableau I.

L'indication "bas" correspond au niveau bas des signaux et l'indication "haut" au niveau haut des signaux. La référence M désigne la masse.

Avec les conditions du tableau II et les valeurs des éléments du tableau I, on en déduit les conditions de fonctionnement du circuit, qui sont :

$V_E$(bas) $\leq$ -0,9V et $V_E$(haut) $\geq$ -0,3 V

TABLEAU I

| | |
|---|---|
| Longueur de grille de $T_1$ | $\ell_g$ = 0,5 $\mu$m |
| Largeur de grille de $T_1$ | $W_1$ = 200 $\mu$m |
| Longueur de grille de $T_2$ | $\ell_g$ = 0,5 $\mu$m |
| Largeur de grille de $T_2$ | $W_2$ = 20 $\mu$m |
| Tension de pincement de $T_1$ et $T_2$ | $V_T \simeq$ -0,6 V |
| $L_G$ = 0,2 nH | $C_G$ = 10pF |
| $L_D$ = 2 nH | $C_D$ = 10 pF |
| $L_S$ = 2 nH | $C_S$ = 0,030 pF |
| $L_F$ = 0,5 nH | $C_1$ = 10 pF |
| La fréquence d'oscillation | $f_u$ = 76 GHz |
| Le temps de transit | $T_O$ = 5,3 ps |

**TABLEAU II**

$V_E$(bas) $\langle$ $V_{G1,M}$(bas) + $V_T$ pour bloquer $T_2$

$V_E$(haut $\rangle$ $V_{G1,M}$(haut) + $V_T$

or $V_{G1,M}$(bas) = $V_{G1,S1}$ = -0,3V

$V_{G1,M}$(haut) = $V_{G1,S1}$ = +0,3V

$V_T$ = -0,6 V

d'où $V_E$(bas) $\langle$ -0,9V et $V_E$(haut) $\rangle$ -0,3V

**Revendications**

1. Dispositif semiconducteur intégré incluant un circuit diviseur de fréquence par deux comprenant un étage inverseur et un interrupteur commandé par un signal d'entrée E à une fréquence donnée, caractérisé

5

en ce que l'arrangement du circuit diviseur comprend :

- un oscillateur formé de l'étage inverseur muni d'un élément réactif $Z_f$ générant une résistance négative,
- l'interrupteur disposé en parallèle sur l'élément réactif $Z_f$,
- le contrôle de l'oscillateur par l'interrupteur en remplissant les conditions :

$\tau_2 > \tau_0$

$1/2 (\tau_0 + \tau_1) < f_0 < 1/(\tau_0 + \tau_1)$

$1/(\tau_1 + \tau_2) < f_0$

où $\tau_0$ est le temps de fermeture de l'interrupteur,

$\tau_1$ est le retard apporté par l'étage inverseur,

$\tau_2$ est le temps de transit dans l'élément réactif $Z_f$.

$f_0$ est la fréquence du signal d'entrée E.

2. Dispositif selon la revendication 1, caractérisé en ce que, dans l'oscillateur, l'étage inverseur comprend un transistor à effet de champ $T_1$ muni d'impédances d'accord.

3. Dispositif selon la revendication 2, caractérisé en ce que l'interrupteur comprend un transistor à effet de champ $T_2$ dont la source et le drain sont respectivement reliés aux extrémités de l'élément réactif $Z_f$ et dont la grille reçoit le signal d'entrée E.

4. Dispositif selon la revendication 3, caractérisé en ce que l'élément réactif $Z_f$ comprend une ligne de transmission $L_f$ et une capacité $C_1$ placées entre la grille et le drain du transistor $T_1$ inverseur.

5. Dispositif selon la revendication 4, caractérisé en ce que les impédances d'accord comprennent des lignes de transmission.

6. Dispositif selon la revendication 5, caractérisé en ce que, pour réaliser les impédances d'accord, une première ligne de transmission est disposée entre la grille du transistor $T_1$ inverseur et la masse, une seconde ligne de transmission en parallèle avec une capacité est disposée entre la source de ce transistor et la masse, et une troisième ligne de transmission est disposée entre le drain de ce transistor et la masse.

7. Dispositif selon l'une des revendications 3 à 6, caractérisé en ce que l'étage inverseur est muni d'une charge $R_\ell$ appliquée entre le drain et la masse M, la sortie hyperfréquences S se faisant sur le drain du transistor $T_1$ de l'étage inverseur.

8. Dispositif selon l'une des revendications 3 à 7, caractérisé en ce que l'étage inverseur inclut en outre des moyens de polarisation comprenant une capacité disposée en série avec l'impédance d'accord entre la grille du transistor inverseur $T_1$ et la masse et une capacité disposée en série avec l'impédance d'accord entre le drain du transistor inverseur et la masse.

9. Dispositif selon l'une des revendications 3 à 8, caractérisé en ce que l'électrode de commande du transistor $T_2$ est reliée à la masse à travers la résistance $R_E$ en série avec une capacité, et en ce qu'une tension de polarisation est appliquée au point commun de cette résistance $R_E$ et de la capacité.

10. Dispositif selon l'une des revendications 7 à 9, caractérisé en ce qu'un circuit d'adaptation de puissance est disposé entre le drain du transistor inverseur $T_1$ et la sortie S, la résistance de charge $R_\ell$ étant alors appliquée entre la sortie S et la masse.

11. Dispositif selon l'une des revendications 3 à 10, caractérisé en ce qu'il est monolithiquement intégré sur un substrat dans une technologie mettant en oeuvre des transistors à effet de champ du type dit MESFET ou HEMT, à désertion, en arséniure de gallium.

12. Dispositif selon la revendication 11, caractérisé en ce que la largeur de grille du transistor inverseur $T_1$ est plus grande que la largeur de grille du transistor interrupteur $T_2$, en ce que leur tension de pincement $V_T$ est de l'ordre de -0,6 V, et en ce que ces conditions de fonctionnement du circuit s'expriment alors par les relations :

$V_E(bas) \leq -0,9$ V

$V_E(haut) \geq -0,3$ V·

relations dans lesquelles $V_E(bas)$ est le niveau bas du signal d'entrée E, et $V_E(haut)$ est le niveau haut de ce signal d'entrée.

FIG.1

FIG.2

FIG.3

Office européen
des brevets

RAPPORT DE RECHERCHE EUROPEENNE

Numero de la demande

EP  89 20 3265

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A,D | TECHNICAL DIGEST OF THE GaAs IC SYMPOSIUM, Portland, Oregon, 13-16 octobre 1987, pages 201-204, IEEE, New York, US; J.F. JENSEN et al.: "26-GHz GaAs room-temperature dynamic divider circuit"<br>* Figure 6 *<br>--- | 1 | H 03 B 19/14<br>H 03 K 5/00 |
| A | ELECTRONIC LETTERS, vol. 9, no. 4, 22 février 1973, pages 85-86; L.C. UPADHYAYULA et al.: "Microwave frequency division using transferred-electron devices"<br>* Page 85, colonne de gauche *<br>--- | 1 | |
| A,D | IEEE TRANSACTIONS ON MICROWAVE THEORY AND TECHNIQUES, vol. MTT-32, no. 11, novembre 1984, pages 1461-1468, IEEE, New York, US; C. RAUSCHER: "Regenerative frequency division with a GaAs FET"<br>* Figure 3 *<br>--- | 1 | |
| A | ELECTRONIC LETTERS, vol. 23, no. 20, 24 septembre 1987, pages 1085-1087, Londres, GB; I. KIPNIS: "20GHz frequency-divider silicon bipolar MMIC"<br>* Figure 1 *<br>--- | 1 | DOMAINES TECHNIQUES RECHERCHES (Int. Cl.5)<br><br>H 03 B<br>H 03 K<br>H 03 L |
| A | EP-A-0 130 645 (LEP)<br>* Résumé *<br>----- | 1 | |

Le présent rapport a été établi pour toutes les revendications

| Lieu de la recherche | Date d'achèvement de la recherche | Examinateur |
|---|---|---|
| LA HAYE | 06-04-1990 | DHONDT I.E.E. |